# EUROPEAN PATENT APPLICATION

(11) **EP 2 750 182 A1**
(43) Date of publication of application: **02.07.2014**
(21) Application number: 12306705.0
(22) Date of filing: 28.12.2012
(51) Int. Cl.: H01L 23/10, H01L 23/552, H01L 21/50, H01L 21/52, H01L 21/54, H01L 23/20

(54) **Electronic device sealing for a downhole tool**

(71) Applicant: Services Pétroliers Schlumberger, 75007 Paris (FR); SCHLUMBERGER TECHNOLOGY B.V., 2514 JG The Hague (NL); Schlumberger Holdings Limited, Tortola 1110 (VG); PRAD Research and Development Limited, Road Town, Tortola 1110 (VG)
(72) Inventor: Barbara, Francois, 92142 Clamart Cedex (FR); Martinez-Llorca, Vincent, Sugar Land, TX Texas 77478 (US)
(74) Representative: Rzaniak, Martin

(57) **Abstract**

Systems, methods, and devices that have a hermetic seal formed using reflow soldering are provided. The hermetic seal may protect electrical components within a packaging for use in downhole tools and/or other applications where the electrical components may be exposed to extreme environments. In one example, an electronic device includes a ceramic substrate having a plated ring. The electronic device also includes a metal lid. A high-temperature solder is disposed between the plated ring of the ceramic substrate and the metal lid. The electronic device includes a hermetically sealed cavity formed between the ceramic substrate and the metal lid. The hermetically sealed cavity is formed via a first bond between the plated ring of the ceramic substrate and the high-temperature solder, and via a second bond between the metal lid and the high-temperature solder. Moreover, the first and second bonds are formed using reflow soldering.

## Description

### BACKGROUND

This disclosure relates to hermetically sealing electronic devices for use in high temperature environments, such as for use in a downhole tool.

This section is intended to introduce the reader to various aspects of art that may be related to various aspects of the present techniques, which are described and/or claimed below. This discussion is believed to be helpful in providing the reader with background information to facilitate a better understanding of the various aspects of the present disclosure. Accordingly, it should be understood that these statements are to be read in this light, and not as admissions.

Tools used in downhole applications often operate within extreme environments, such as high temperature, high pressure, and/or high shock environments. Such downhole tools may include, for example, measurement-while-drilling (MWD) tools, logging-while-drilling (LWD) tools, wireline tools, coiled tubing tools, testing tools, completion tools, production tools, or combinations thereof. In an example of a MWD system, a drill bit attached to a long string of drill pipe, generally referred to as the drill string, may be used to drill a borehole for an oil and/or gas well. In addition to the drill bit, the drill string may also include a variety of downhole tools to measure or log properties of the surrounding rock formation or the conditions in the borehole. In certain configurations, downhole tools may be used that are not part of a drill string. In either configuration, downhole tools often operate in extreme environments.

Electronic devices may be hermetically sealed to operate in extreme environments. In certain configurations, the electronic devices may be hermetically sealed by placing the electronic devices inside a box sealed by a laser, while in other configurations the electronic devices may be hermetically sealed using a ceramic substrate with a kovar ring sealed using a seam-welding process. However, it may not be cost effective for certain applications to seal a box using a laser, and a size of the electronic device may be limited when using the seam-welding process due to substrate manufacturing constraints. For example, the size of the electronic device may be limited to a size of less than approximately five centimeters (cm) wide by approximately five cm long. Accordingly, a number of electronic components that may be physically located within the electronic device may be limited.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

Present embodiments relate to systems and devices that have a hermetic seal formed using reflow soldering to protect electrical components, and to methods for manufacturing such systems and devices. Such electrical components may be used in downhole tools and/or other applications where the electrical components may be exposed to extreme environments. The present techniques may apply to downhole tools including but not limited to any MWD tool, LWD tool, wireline tool, coiled tubing tool, testing tool, completion tool, production tool, or combinations thereof. In one example, an electronic device includes a ceramic substrate having a plated ring (e.g., metal ring). The electronic device also includes a metal lid. A high-temperature solder is disposed between the plated ring of the ceramic substrate and the metal lid. The high-temperature solder has a melting point of at least 200 degrees Celsius. The electronic device includes a hermetically sealed cavity formed between the ceramic substrate and the metal lid. The hermetically sealed cavity is formed via a first bond between the plating ring of the ceramic substrate and the high-temperature solder, and via a second bond between the metal lid and the high-temperature solder. Moreover, the first and second bonds are formed using reflow soldering.

In another example, a method may include depositing solder on a ceramic substrate. The method may also include disposing a lid directly on the solder. Furthermore, the method may include sealing the lid to the solder using reflow soldering to form a sealed enclosure.

In a further example, a system may include a downhole tool that measures parameters related to the system and/or a rock formation. Moreover, the system may also include an electronic device having a ceramic substrate with a plated ring. The electronic device also includes a metal lid. A high-temperature solder is disposed between the plated ring of the ceramic substrate and the metal lid. The high-temperature solder has a melting point of at least 200 degrees Celsius. The electronic device includes a hermetically sealed cavity formed between the ceramic substrate and the metal lid. The hermetically sealed cavity is formed via a first bond between the plated ring of the ceramic substrate and the high-temperature solder, and via a second bond between the metal lid and the high-temperature solder. Moreover, the first and second bonds are formed using reflow soldering.

Various refinements of the features noted above may exist in relation to various aspects of this disclosure. Further features may also be incorporated in these various aspects as well. These refinements and additional features may exist individually or in any combination. For instance, various features discussed below in relation to one or more of the illustrated embodiments may be incorporated into any of the above-described aspects of this disclosure alone or in any combination. The brief summary presented above is intended to familiarize the reader with certain aspects and contexts of embodiments of this disclosure without limitation to the claimed subject matter.

### BRIEF DESCRIPTION OF THE DRAWINGS

Various aspects of this disclosure may be better understood upon reading the following detailed description and upon reference to the drawings in which:

FIG. 1 is a schematic diagram of a downhole tool that employs a hermetically sealed electronic device for operating in extreme environments, in accordance with an embodiment;

FIG. 2 is a block diagram of a hermetically sealed electronic device, in accordance with an embodiment;

FIG. 3 is a flowchart of a method for manufacturing a hermetically sealed electronic device, in accordance with an embodiment;

FIG. 4 is a top view of a ceramic substrate of an electronic device having a plated ring for hermetically sealing the electronic device, in accordance with an embodiment;

FIG. 5 is a top view of the ceramic substrate of FIG. 4 having solder disposed on the plated ring, in accordance with an embodiment;

FIG. 6 is a top view of the ceramic substrate of FIG. 5 after a solder reflow, in accordance with an embodiment; and

FIG. 7 is an assembly view of a hermetically sealed electronic device, in accordance with an embodiment.

### DETAILED DESCRIPTION

One or more specific embodiments of the present disclosure will be described below. These described embodiments are examples of the presently disclosed techniques. Additionally, in an effort to provide a concise description of these embodiments, certain features of an actual implementation may not be described in the specification. It should be appreciated that in the development of any such actual implementation, as in any engineering or design project, numerous implementation-specific decisions may be made to achieve the developers' specific goals, such as compliance with system-related and business-related constraints, which may vary from one implementation to another. Moreover, it may be appreciated that such a development effort might be complex and time consuming, but would nevertheless be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features.

As mentioned above, this disclosure relates to hermetically sealing electronic devices for use in downhole tools. For example, drilling a borehole for an oil and/or gas well often involves a drill string-several drill pipes and a drill bit, among other things-that grinds into a rock formation when drilling fluid is pumped through the drill string. In addition to the drill bit, the drill string may also include several electrically powered tools. The tools in the drill string may include, for example, logging-while-drilling (LWD) tools, measurement-while-drilling (MWD) tools, steering tools, and/or tools to communicate with drilling operators at the surface.

In general, the borehole may be drilled by pumping drilling fluid into the tool string, causing the drill bit to rotate and grind away rock as the drilling fluid passes through. The hydraulic power of the drilling fluid may also be used to generate electricity. Specifically, a turbine generator may convert some of the hydraulic power of the drilling fluid into electrical power. During operation of the tool string, the electrically powered tools may be exposed to extreme environmental conditions, such as high temperature, high pressure, and high shock environments. Furthermore, electronic devices used within the electrically powered tools may be exposed to the extreme environmental conditions.

Accordingly, the hermetically sealed electronic device described in this disclosure may be used within the electrically powered tools. Moreover, the hermetically sealed electronic device may operate reliably in extreme environmental conditions, such as high temperature environments. As such, the hermetically sealed electronic device may be physically located within the extreme environmental conditions. Furthermore, using techniques described herein, the hermetically sealed electronic device may be manufactured to be larger then other hermetically sealed electronic devices, thereby enabling a greater number of electrical components to be housed within the hermetically sealed electronic device.

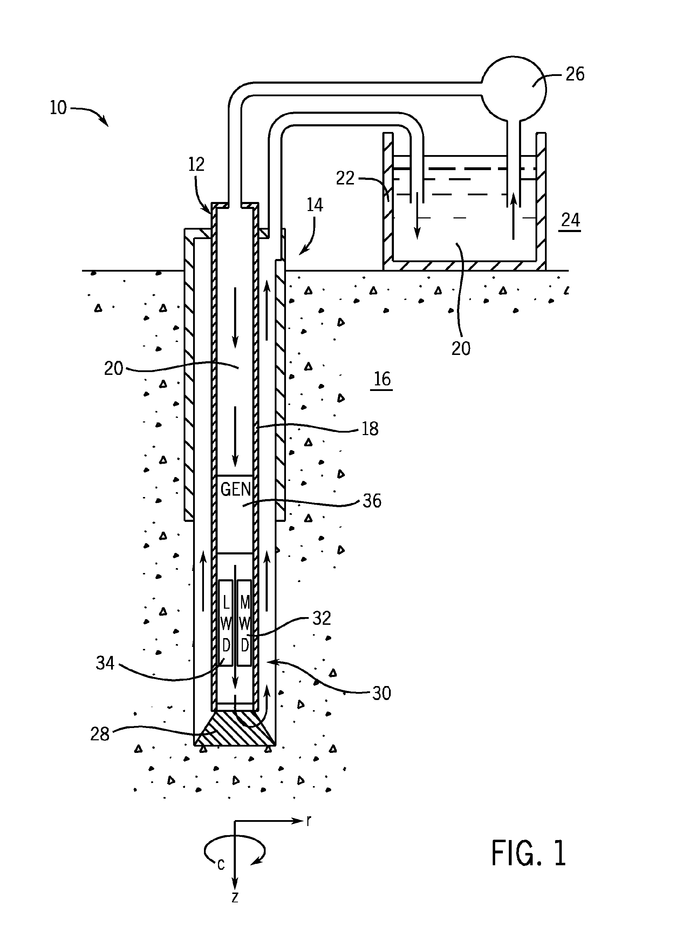

A downhole tool 10, shown in FIG. 1, may benefit from the hermetically sealed electronic device mentioned above. The downhole tool 10 of FIG. 1 includes a drill string 12 used to drill a borehole 14 into a rock formation 16. A drill collar 18 of the drill string 12 encloses the various components of the drill string 12. Drilling fluid 20 from a reservoir 22 at a surface 24 may be driven into the drill string 12 by a pump 26. The hydraulic power of the drilling fluid 20 causes a drill bit 28 to rotate, cutting into the rock formation 16. The cuttings from the rock formation 16 and the returning drilling fluid 20 exit the drill string 12 through a space 30. The drilling fluid 20 thereafter may be recycled and pumped, once again, into the drill string 12.

A variety of information relating to the rock formation 16 and/or the state of drilling of the borehole 14 may be gathered while the drill string 12 drills the borehole 14. For instance, a measurement-while-drilling (MWD) tool 32 may measure certain drilling parameters, such as the temperature of the drilling tool, pressure on the drilling tool, orientation of the drilling tool, and so forth. Likewise, a logging-while-drilling (LWD) tool 34 may measure the physical properties of the rock formation 16, such as density, porosity, resistivity, and so forth. These tools and other tools may rely on electrical power for their operation. As such, a turbine generator 36 may generate electrical power from the hydraulic power of the drilling fluid 20.

As seen in FIG. 1, the drill string 12 is generally aligned along a longitudinal z-axis. Components of the drill string 12 may be located within the drill string at various radial distances from the z-axis, as illustrated by a radial r-axis. Certain components, such as the turbine generator 36 may include parts that rotate circumferentially along a circumferential c-axis.

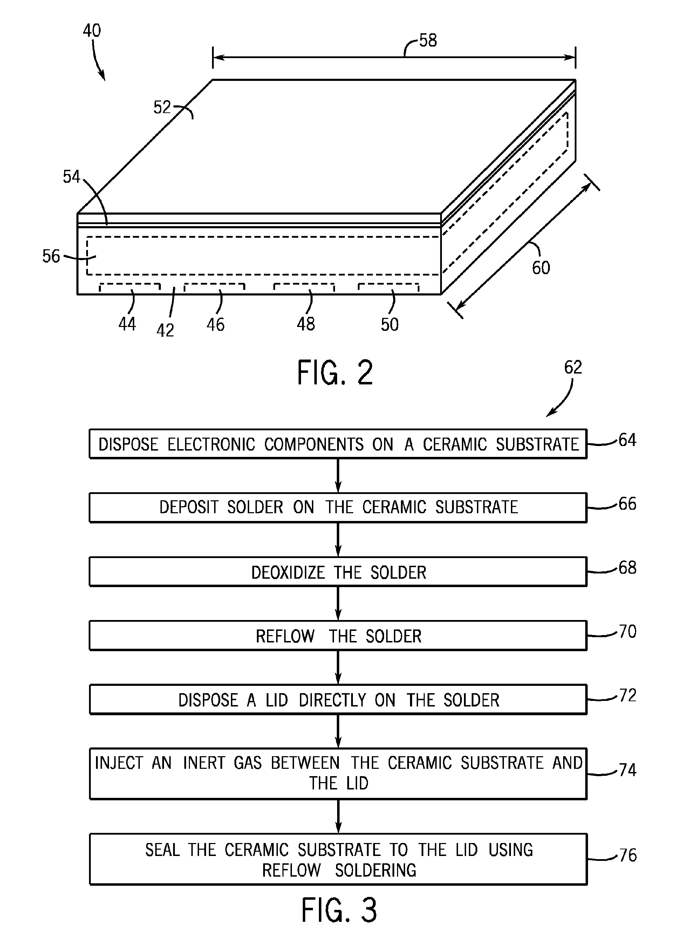

One type of hermetically sealed electronic device 40 is illustrated in FIG. 2. The electronic device 40 includes a substrate 42 (e.g., ceramic substrate). In certain embodiments, the substrate 42 is formed from a material that facilitates operation of the electronic device 40 in high temperature environments. For example, the substrate 42 may be designed to operate in environments with temperatures up to 150 degrees Celsius, 200 degrees Celsius, 220 degrees Celsius, 240 degrees Celsius, or in environments with higher temperatures. Electronic components 44, 46, 48, and 50 may be disposed on the substrate 42. In certain embodiments, the electronic components 44, 46, 48, and 50 may be integrated with the substrate 42. Moreover, in some embodiments, the electronic components 44, 46, 48, and 50 and the substrate 42 may together form a multi-chip module (MCM). Furthermore, the electronic components 44, 46, 48, and 50 may be assembled on the substrate 42 and interconnected via wire-bonding.

The electronic components 44, 46, 48, and 50 may be any suitable type of electronic component. For example, the electronic components 44, 46, 48, and 50 may be integrated circuits, hybrid integrated circuits, semiconductors, thick film devices, microchips, processors, resistors, capacitors, diodes, transistors, inductors, optoelectronic devices, transducers, sensors, switches, and so forth. Furthermore, the number of electronic components disposed on the substrate 42 may vary between different electronic devices. Accordingly, there may be fewer than, or more than, four electronic components integrated with the substrate 42.

The electronic device 40 includes a lid 52. The lid 52 may be formed from a metal or a metal based material to facilitate hermetically sealing the electronic device 40. For example, in the illustrated embodiment, the lid 52 is sealed to the substrate 42 using solder 54. The solder 54 may be any suitable high temperature solder (e.g., medium melting point (MMP)) that may withstand high temperatures. For example, the solder 54 may withstand temperatures up to 150 degrees Celsius, 200 degrees Celsius, 220 degrees Celsius, 240 degrees Celsius, or higher temperatures. As explained in detail below, reflow soldering may be used to form a first bond between the solder 54 and the lid 52, and to form a second bond between the solder 54 and the substrate 42, thereby sealing the lid 52 to the substrate 42. As may be appreciated, the first and second bonds may be formed during a single reflow process, or during multiple reflow processes. In some embodiments, any suitable soldering technique may be used to form the first and second bonds. With the lid 52 sealed to the substrate 42, a hermetically sealed cavity 56 is formed within the electronic device 40. Accordingly, the electronic components 44, 46, 48, and 50 may be enclosed within the hermetically sealed cavity 56 and may avoid external contact, thereby facilitating decreased migration, condensation, corrosion, and so forth.

The electronic device 40 may have any suitable length 58 and any suitable width 60. For example, the length 58 of the electronic device 40 and/or the width 60 of the electronic device 40 may be greater than approximately 2 centimeters (cm), 4 cm, 5 cm, 10 cm, 20 cm, or more. Accordingly, the length 58 and/or the width 60 of the electronic device 40 may be greater than other hermetically sealed electronic devices, such as electronic devices hermetically sealed using seam welding. Therefore, the hermetically sealed cavity 56 of the electronic device 40 may have a greater volume and, thereby, may facilitate enclosing a greater number and/or size of electronic components 44, 46, 48, and 50.

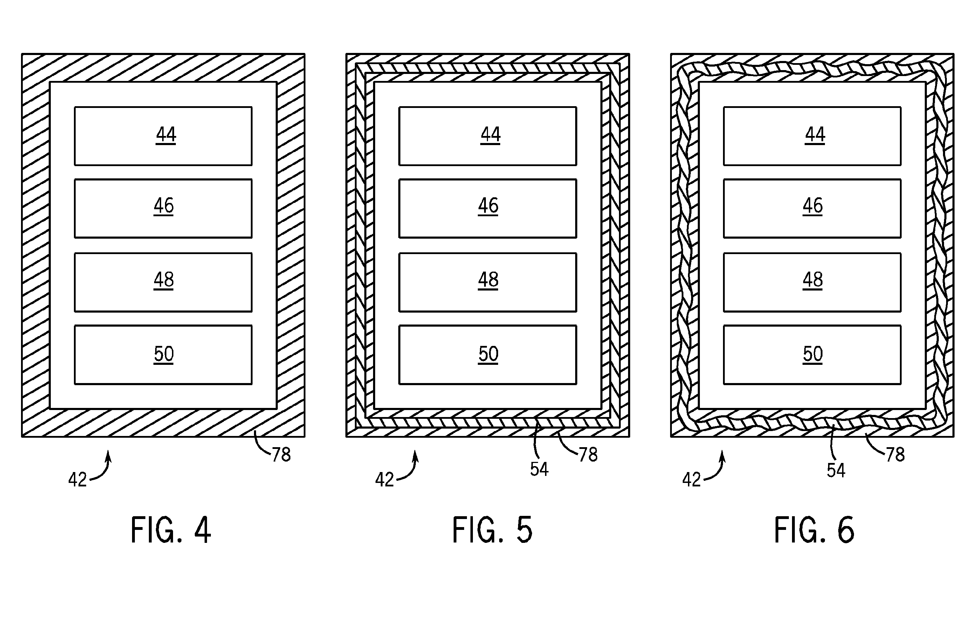

The electronic device 40 may be hermetically sealed using a variety of different techniques. FIG. 3 is a flowchart of a method 62 illustrating one technique for manufacturing a hermetically sealed electronic device. Moreover, FIGS. 4 through 7 illustrate portions of the method 62 and, therefore, will be discussed in conjunction with FIG. 3. Accordingly, electronic components (e.g., electronic components 44, 46, 48, 50) may be disposed on a ceramic substrate (e.g., substrate 42) (block 64). In certain embodiments, a MCM may be formed using the ceramic substrate. The ceramic substrate may include a plated ring 78 to facilitate bonding solder to the ceramic substrate, as illustrated in FIG. 4. The plated ring 78 may extend around the circumference (e.g., edges) of the ceramic substrate.

Returning to the method 62, solder (e.g., solder 54) may be deposited on the ceramic substrate (block 66). The solder may be deposited on the plated ring 78, as illustrate by the solder 54 in FIG. 5. Moreover, the solder may be deposited on the ceramic substrate using any suitable deposition technique. For example, in certain embodiments, the solder may be deposited on the ceramic substrate using a screen printing process. In other embodiments, the solder may be deposited on the ceramic substrate using evaporation, sputtering, electrolytic deposition, and so forth. The solder may be deoxidized before a lid is hermetically sealed to the ceramic substrate to improve the bond between the solder, the lid, and the ceramic substrate (block 68). In certain embodiments, the solder may be deoxidized by applying a gas to the solder, such as formic acid gas. In other embodiments, the solder may be deoxidized by applying any suitable material to the solder.

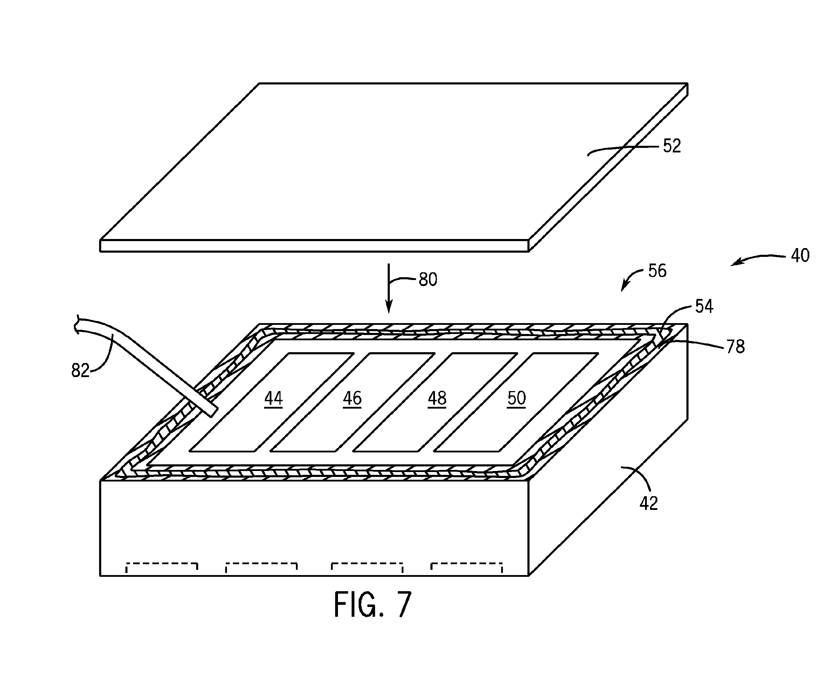

After the solder is deposited on the ceramic substrate, a reflow process may be applied to the solder to bond the solder to the ceramic substrate (block 70). Such a reflow process may alter the area of the plated ring 78 covered by the solder, as illustrated in FIG. 6. After reflowing the solder applied to the plated ring 78, the lid (e.g., lid 52) may be disposed directly on the solder (block 72), as illustrated by arrow 80 in FIG. 7. Moreover, an inert gas may be injected between the ceramic substrate and the lid (block 74), as illustrated by gas injection device 82 in FIG. 7. The inert gas may facilitate a decrease in moisture, corrosion, and/or degradation of electronic components formed within the hermetically sealed cavity. As may be appreciated, the inert gas may be any suitable gas, such as nitrogen or argon. Accordingly, the inert gas may occupy the hermetically sealed cavity. The ceramic substrate may be sealed to the lid using reflow soldering to form a sealed enclosure (block 76). As may be appreciated, the sealed enclosure may be a hermetically sealed enclosure.

One or more of blocks 64, 66, 68, 70, 72, 74, and 76 may occur within an enclosed device, such as an oven, a vacuum, a vacuum oven, and so forth. For example, the reflow soldering of blocks 70 and 76 may occur within an oven. During the reflow soldering, the solder may be bonded to both the ceramic substrate and to the lid. Moreover, reflow soldering may include multiple sub-processes, such as a preheat process, a dryout process, a reflow process, and a cooling process that all occur within the oven. During the preheat process, the oven may be gradually heated at a controlled rate, such as by heating the oven from an ambient temperature to a temperature below the melting point of the solder. For example, the oven may be heated gradually at a rate of between one to four degrees Celsius per second from an ambient temperature to approximately 280 degrees Celsius for a solder with a melding point of approximately 240 degrees Celsius. By heating the oven at a controlled rate, thermal shock on the electronic device 40 may be reduced.

During the dryout process, the oven may be consistently held for a period of time (e.g., 60 to 120 seconds) to facilitate uniform heating of the electronic device 40. For example, the temperature of the electronic device 40 may be consistently held at approximately 280 degrees Celsius for approximately 60 to 120 seconds. Moreover, during the reflow process the temperature of the oven is raised to a temperature greater than the melting point of the solder (e.g., a peak temperature). For example, the temperature of the oven may be raised to exceed the melting point of the solder by approximately 20 degrees Celsius to facilitate a strong bond between the solder, the lid, and the ceramic substrate. Accordingly, for a solder with a melting point of approximately 240 degrees Celsius, the temperature of the oven may transition from a preheat process temperature of approximately 280 degrees Celsius to a reflow process temperature of approximately 280 degrees Celsius. After reaching the peak temperature, a cooling process may begin. During the cooling process, the temperature of the oven may be cooled at a controlled rate, such as by decreasing the temperature of the oven at a rate of between approximately one and two degrees Celsius per second. A wetting time refers to the amount of time that the solder is above the melting point of the solder. In certain embodiments, the wetting time may be held to be within 30 to 60 seconds to facilitate a strong solder joint.

As explained herein, the electronic device 40 that is hermetically sealed using reflow soldering may be used for downhole tools operating in extreme environmental conditions, such as high temperature environments. Accordingly, the electronic device 40 may be manufactured to have a greater volume than electronic devices hermetically sealed using seam welding and, thereby, may facilitate enclosing a greater number and/or size of electronic components. It may be appreciated that while drilling systems such as MWD and LWD systems have been provided as examples in this specification, the present techniques may apply to any MWD tool, LWD tool, wireline tool, coiled tubing tool, testing tool, completions tool, production tool, or combinations thereof

The specific embodiments described above have been shown by way of example, and it should be understood that these embodiments may be susceptible to various modifications and alternative forms. It should be further understood that the claims are not intended to be limited to the particular forms disclosed, but rather to cover modifications, equivalents, and alternatives falling within the spirit and scope of this disclosure.

## Claims

1. An electronic device (40) comprising:
a ceramic substrate (42) having a plated ring (78);
a metal lid (52);
a high-temperature solder (54) disposed between the plated ring (78) of the ceramic substrate (42) and the metal lid (52), wherein the high-temperature solder (54) has a melting point of at least 200 degrees Celsius; and
a hermetically sealed cavity (56) formed between the ceramic substrate (42) and the metal lid (52);
wherein the hermetically sealed cavity (56) is formed via a first bond between the plated ring (78) of the ceramic substrate (42) and the high-temperature solder (54), and via a second bond between the metal lid (52) and the high-temperature solder (54), and wherein the first and second bonds are formed using reflow soldering.

2. The electronic device (40) of claim 1, wherein the ceramic substrate (42) has a length larger than seven centimeters and a width larger than two centimeters.

3. The electronic device (40) of claim 1, wherein the melting point of the high-temperature solder (54) is greater than 230 degrees Celsius.

4. The electronic device (40) of claim 1, wherein the hermetically sealed cavity (56) comprises a plurality of electronic components (44, 46, 48, 50).

5. The electronic device (40) of claim 1, wherein the hermetically sealed cavity (56) comprises an inert gas.

6. A method (62) comprising:
depositing solder (54) on a ceramic substrate (42);
disposing a lid (52) directly on the solder (54); and
sealing the lid (52) to the solder (54) using reflow soldering to form a sealed enclosure (56).

7. The method (62) of claim 6, wherein depositing the solder (54) on the ceramic substrate (42) comprising screen printing the solder (54) on the ceramic substrate (42).

8. The method (62) of claim 6, wherein depositing the solder (54) on the ceramic substrate (42) comprises depositing solder (54) on a plated ring (78) of the ceramic substrate (42).

9. The method (62) of claim 6, wherein sealing the lid (52) to the solder (54) using reflow soldering to form the sealed enclosure (56) comprises hermetically sealing the sealed enclosure (56).

10. The method (62) of claim 6, wherein the reflow soldering comprises a preheat process, a dryout process, a reflow process, and a cooling process.

11. The method (62) of claim 6, comprising disposing electronic components (44, 46, 48, 50) on the ceramic substrate (42).

12. The method (62) of claim 6, comprising forming a multi-chip module (44, 46, 48, 50) using the ceramic substrate (42) before depositing the solder (54) on the ceramic substrate (42).

13. The method (62) of claim 6, comprising deoxidizing the solder (54) by applying a gas to the solder (54).

14. The method (62) of claim 6, comprising injecting an inert gas between the ceramic substrate (42) and the lid (52), wherein the inert gas occupies a cavity (56) within the sealed enclosure (56).

15. The method (62) of claim 6, comprising reflowing the solder (54) before disposing the lid (52) directly on the solder (54).
